Europäisches Patentamt

European Patent Office

Office européen des brevets

(11) Publication number: 0 400 651
A2

# EUROPEAN PATENT APPLICATION

(21) Application number: 90110374.7

(51) Int. Cl.5: H01L 21/306

(22) Date of filing: 31.05.90

(30) Priority: 31.05.89 JP 136017/89

(43) Date of publication of application:
05.12.90 Bulletin 90/49

(84) Designated Contracting States:
DE FR GB

(71) Applicant: HITACHI, LTD.
6, Kanda Surugadai 4-chome
Chiyoda-ku, Tokyo 100(JP)

(72) Inventor: Mochiji, Kozo
17-3-301, Oiwakecho
Hachioji-shi(JP)

Inventor: Soda, Yasunari
Hitachi Koyasudai Apt. D304
32, Koyasumachi 2-chome, Hachioji-shi(JP)
Inventor: Kimura, Takeshi
11-18, Meguritacho 2-chome
Higashimurayama-shi(JP)

(74) Representative: Altenburg, Udo, Dipl.-Phys. et
al
Patent- und Rechtsanwälte
Bardehle-Pagenberg-Dost-Altenburg
Frohwitter-Geissler & Partner Postfach 86 06
20
D-8000 München 86(DE)

(54) Method of modification on surface of solid sample.

(57) A method of modification of a solid sample surface which comprises irradiating the surface with X-ray or electron beam having an energy over the ionization energy of core electrons of atoms composing the surface thereby to selectively desorbe specific atoms present on the surface and change the atomic composition of the surface without causing recontamination and damage on the surface.

F I G. IA

F I G. IE

# METHOD OF MODIFICATION ON SURFACE OF SOLID SAMPLE

## BACKGROUND OF THE INVENTION

This invention generally relates to a method of solid surface modification on a solid surface, and particularly to cleaning of a semiconductor wafer surface.

With high density integration of LSI, cleaning of the semiconductor wafer surface has become increasingly important. For this reason, it is required to selectively remove a very thin oxide layer and dirt on the surface without causing any damage and contamination on the semiconductor wafer. At present, however, no ideal method has been found therefor. Of some proposed methods, the method of chemically etching $SiO_2$ on an Si wafer surface in HF vapor is considered to be the most promising, as is described in "Etching of Native Oxide on Si Wafer Surface with Anhydrous Vapor HF" (The Proceeding of 34th Symposium on the Technology of Semiconductor and Integrated Circuit, p. 31, Tokyo 1988). Since, however, this method requires heating or since water vapor is used in combination, big problems such as difficulty in avoiding a recontamination on the Si wafer surface, etc., remain to be solved.

Another method has been proposed in which adsorption atoms are desorbed by irradiating a semiconductor wafer surface with light having the same energy as that of the binding energy between a surface atom and the adsorption atom (Japanese Patent Unexamined Publication No. 64-8631). In this method, however, since the disconnected bond is rapidly restored, the probability of the adsorption atoms being desorbed is very small. Further, another method has been proposed which comprises multi-irradiating a surface with an infrared laser and ultraviolet laser to desorb surface atoms (Japanese Patent Unexamined Publication No. 61-87338). Since, however, this method uses thermal desorption under heat with a laser, the possiblity of atoms adsorbed on the surface being selectively desorbed is low.

Further, Japanese Patent Unexamined Publication No. 62-130512 discloses a method of removing an oxide layer by irradiation with an As molecular beam. In the case of the molecular beam, however, surface atoms are sputtered by kinetic energy conversion of a particle as in the above irradiation with ions, which results in low selectivity and large damage on a semiconductor wafer.

The above conventional techniques have not taken into consideration any selectivity of a chemical reaction taking place on the surface, and at the same time, such techniques have problems such as recontamination, damage occurrence, etc.

## SUMMARY OF THE INVENTION

It is an object of this invention to provide a method of solid surface modification which is capable of selectively desorbing specific molecules or atoms from the solid surface without causing recontamination and damage.

In order to achieve the above object, this invention provides a method of modification on the surface of a solid sample, which comprises irradiating the surface of the solid sample with X-ray or electron beam having an energy over the ionization energy of the core electrons of atoms composing the solid sample surface thereby to selectively desorb specific atoms present on the solid sample surface.

In order to effectively carry out the surface reaction under the irradiation with X-ray or electron beam, the above modification method comprises, more preferably, introducing a gas into the atmosphere for the irradiation. For the same purpose, the method also comprises forming a molecular or atomic adsorption layer on the surface.

According to this invention, the selective removal of a native oxide layer on the semiconductor wafer surface (i.e. surface cleaning) can be carried out more selectively and with less damage than any other conventional methods. When various thin films necessary for semiconductor devices are formed on such cleaned surfaces, the resultant thin films have remarkably improved in quality. For this reason, therefore, the method of this invention greatly contributes to improvement in performance and reliability of the devices.

## BRIEF DESCRIPTION OF THE DRAWINGS

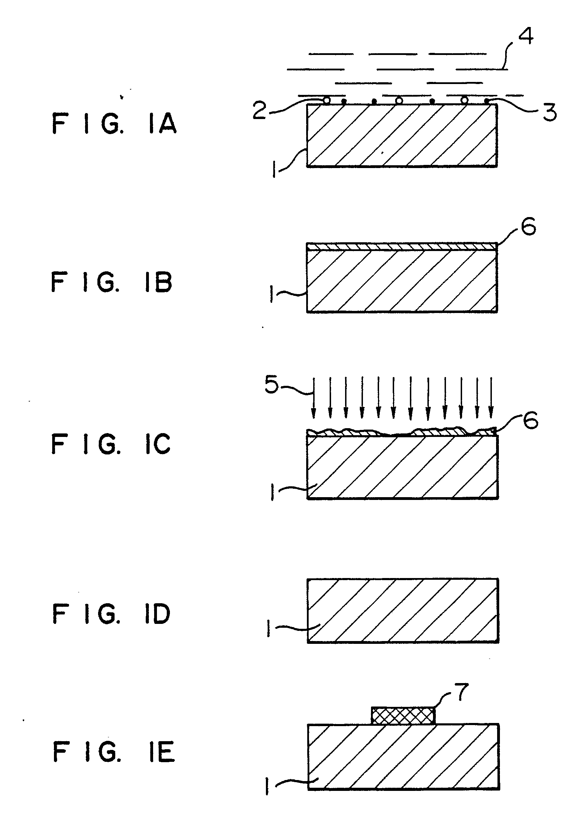

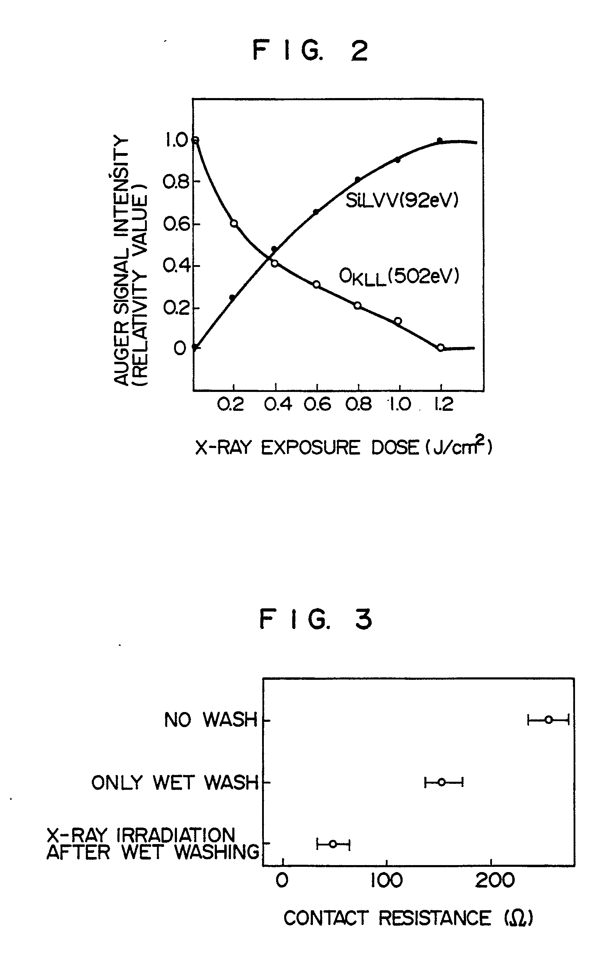

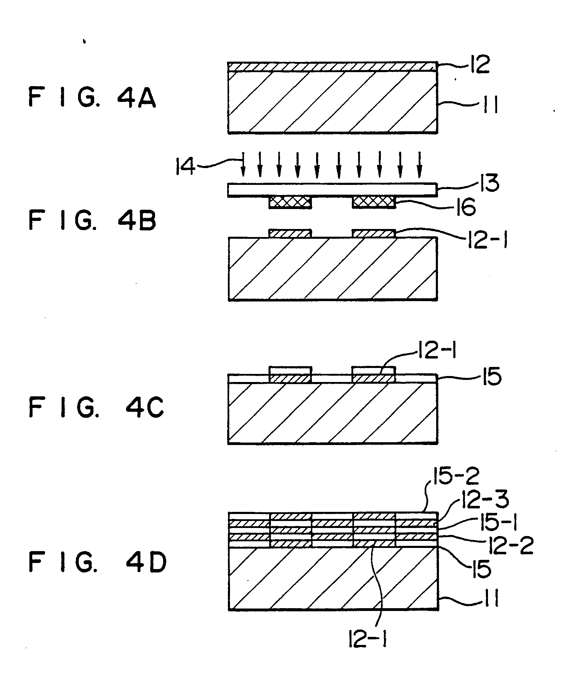

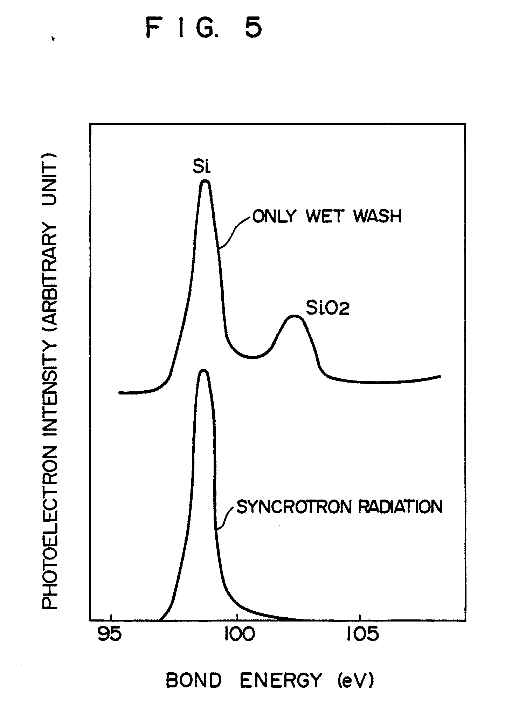

Figs. 1A to 1E are cross sectional views each showing a treatment step in Example 1 according to this invention. Fig. 2 shows the relationship between an X-ray exposure dose and the composition of an Si wafer surface in Example 1. Fig. 3 shows a contact resistance measured in Example 1. Figs. 4A to 4D are cross sectional views showing steps for making a quantum wire in Example 5. Fig. 5 shows the results of photoelectron spectroscopy of Si surfaces achieved in Example 6.

## DESCRIPTION OF THE PREFERRED EMBODIMENTS

First, the principle of the method of this invention is described.

When a solid surface is irradiated with X-ray or electron beam having an energy over the ionization energy of core electrons of atoms composing the surface of a solid surface, specific atoms or atoms composing specific molecules among atoms or molecules present on a sample surface are desorbed. In this desorption reaction mechanism, the core electrons of surface atoms or atoms composing surface molecules are excited and ionized, and the multi-electron relaxation of an Auger process, etc., subsequently takes place to form multi-ionized ions on the surface, whereby surface atoms or molecules are desorbed by Coulomb repulsion thereof. In this case, the X-ray or electron beam irradiation causes only electronic excitation on the surface atoms or the atoms composing the surface molecules, and the replacement of atom in lattice is so small as to be negligible as in conventional ion irradiation. Thus, a wafer material suffers little damage for the irradiation.

Further, when the X-ray or electron beam irradiation is carried out either in a gaseous atmosphere or with molecules adsorbed on the surface, the binding state of the surface atoms can be changed, whereby the reaction efficiency of the desorption reaction of specific atoms or molecules can be improved.

In addition, the above radiation particle energy is an photon energy in the case of X-ray or an electron energy in the case of electron beam, and these energies are required to be over the ionization energy of the core electrons in order to cause the desorption.

The present invention can be applied, for example, to the steps shown in the following Table 1.

Table 1

| Previous step | Specific atom or molecule | Adsorption layer/ Substrate | Ionization energy (eV)* |
|---|---|---|---|
| Standing in the air | O | Native oxide layer/Si, Al, W, Cu, etc. | O (532), <br> Si (94, 100, 149, 1839), <br> Al (73, 74, 118, 1560), <br> W (246, 259, 426, 492, 595, 1810, 1872, 2281, 2575, 2820), <br> Cu (931, 951, 1096), etc. |
| Wet cleaning, dry etching | F | F/Si, $SiO_2$, W, Al, etc. | F (686) <br> Si, Al, O, W, Cu, etc. |
| | Cl | Cl/Si, $SiO_2$, W, Al, etc. | Cl (200, 202, 270, 2823) <br> Si, Al, O, W, Cu, etc. |
| Surface stabilization | S | S/III-V group crystals | S (164, 165, 229, 2472), <br> Ga (103, 107, 158, 1116, 1143, 1298), <br> As (141, 147, 204, 1323, 1359, 1527), <br> In (122, 443, 451, 604, 702, 826), <br> Al, etc. |
| Multi-layer structure formation | As | GaAlAs/III-V group crystals | Ga, As, Al, etc. |
| Photolithography | CxHy | CxHy/Si, $SiO_2$, Al, W, etc. | C (284), <br> Si, O, Al, W, Cu, etc. |

Note) * Typical ionization energy of each atom is shown.   – to be cont'd. –

EP 0 400 651 A2

Table 1 (cont'd.)

| Specific region | Gates, contact holes capacitor forming portions of, e.g., semiconductor transistors | = | = | Gates, wiring contact forming portions of, e.g., semiconductor transistors | Quantam well forming portions of, e.g., semiconductor transistors | Gates, contact holes, capacitor forming portions of, e.g., semicondcutor transistors |
|---|---|---|---|---|---|---|
| Reaction gas | None, or $SF_6$, $XeF_2$ (fluorine series), or $CCl_4$ (chlorine series) | None, or $H_2$ | None, or $H_2$ | None, or $F_2$ (fluorine series) | None | $O_2$ |

In the case of the first line of Table 1, a native oxide film (SiO, AlO, etc.) as an adsorption layer for oxygen is formed on the surface of a metal substrate (Si, Al, W, Cu, or the like). The specific atom to be removed is an oxygen atom. When the substrate is exposed to a light (X-rays or electron beams) having energy over the ionization energy of core electrons of atom(s) composing the surface of the substrate (solid sample) or oxygen to be removed, the removal of oxygen becomes possible based on the principle mentioned above. In Table 1, typical values of ionization energy are shown. Further, when a gas containing atoms having high electronegativity such as fluorine series ($SF_6$, $XeF_2$, etc.) or chlorine series ($CCl_4$, etc.) is co-present at the time of irradiation with light (X-rays or electron beams), the oxygen can be removed more effectively. Since the surface reaction is applied, it is effective to cool the substrate for adsorbing these molecules on the surface. Particularly when vacuum exhaustion is carried out again after adsorption, irradiation with light in high vacuum becomes possible, which results in making it possible to make the construction of the light irradiation apparatus relatively easy.

Such a technique for removing a specific atom exhibits its effectiveness when applied to regions such as gates, contact holes, capacitor forming portions, etc., of, e.g., semiconductor transistors, wherein good electroconductivity or insulation is required. Further, it is possible to selectively clean the surfaces of only these portions by exposing the surfaces to the light through a suitable mask.

It is also possible to apply the present invention to removal of F, or Cl on the surface of a substrate treated with a fluorine series or chlorine series solution or gas after a so-called wet cleaning or dry etching. In this case, the use of a light having energy higher than the ionization energy of core electrons of F or Cl is effective.

It is further possible to apply the present invention to a sulfur (S) adsorption layer formed for stabilizing the surface of GaAs substrate, a GaAlAs molecule layer in III-V group multi-layer structure, and an adsorption layer of a hydrocarbon which is a residue of a resist after a photolithographic step, and the like.

As mentioned above, it is possible to remove a specific atom or molecule from the surface of a solid sample such as an adsorption layer containing atoms and molecules generated by a previous step by exciting core electrons of atoms constituting the substrate or adsorption layer.

This invention is explained hereinbelow by reference to Examples.

Example 1

The application of this invention to the cleaning of an Si wafer surface is described referring to Figs. 1A to 1E. A boron-doped (100) Si wafer 1 having a resistivity of 10 $\Omega$-cm was prepared. At first, the wafer was wet-washed with cleaning solutions 4 to remove organic materials 2 such as hydrocarbons, etc., and heavy metals 3 such as Cu, Ag, etc., which adhered to the wafer surface (Fig. 1A). Two kinds of cleaning solutions were used: One of which had a composition of $NH_4OH$, $H_2O_2$ and $H_2O$, and the other, a composition of HCl, $H_2O_2$ and $H_2O$. In general, the former is useful to remove organic materials, and the latter, metals. When the washed Si wafer 1 was dried, the formation of a native oxide layer 6 occurred on its surface (Fig. 1B). Then, the Si wafer 1 was placed in an X-ray exposure chamber, and the chamber was evacuated to not more than $1 \times 10^{-7}$ Pa. Thereafter, the surface of the Si wafer 1 was irradiated with X-ray 5 (Fig. 1C). Synchrotron radiation (electron acceleration energy: 2.5 GeV) was used as an X-ray source. Due to the reflection characteristics of an expansion mirror for synchrotron radiation beam and the transmissivity of a vacuum protection Be aperture of the synchrotron, the wavelength of the X-ray 5 for the irradiation to the sample Si wafer 1 was in the range of 0.5 to 1 nm. The Auger analysis of the atomic composition of the surface of the Si wafer 1 was carried out to measure dependency of the atomic densities of oxygen and simple substance Si on X-ray exposure dose. Fig. 2 is a graph showing the results. The atomic densities were determined on the basis of the intensity of surface Auger electrons ($Si_{LVV}$ and $O_{KLL}$). The graph shows, by irradiation with X-ray 5 having an energy intensity of not less than 1.2 J/cm$^2$, that the $O_{KLL}$ became zero and that the Si wafer 1 had oxygen atoms selectively desorbed from the native oxide layer 6 on the surface and had a surface state of only the simple substance Si (Fig. 1D).

Al was evaporated on the surface of the Si wafer 1 from which the native oxide layer 6 had been removed by the irradiation with the X-ray 5 having an energy intensity of 1.2 J/cm$^2$, and then the evaporated Al was processed into a pattern having a 100 $\mu$m by 100 $\mu$m size (Fig. 1E). The Al pattern was used as an electrode to measure an Al/Si contact resistance. The measurement showed that the contact resistance could be reduced to about 50 $\Omega$, about 1/5 of that in the case of no wash, and about 1/3 of that in the case of conventional wet wash. The reduction in the contact resistance is due to the effect produced by the removal of the native oxide layer 6 from the Si wafer 1 surface, i.e. due to the cleaning of the Si wafer 1 surface.

Example 2

The application of the present invention to formation of an MOS memory capacitor is described below.

The surface of an Si wafer prepared for the formation of an insulator for a capacitor was wet-washed in the same way as in Example 1. The Si wafer was dried and then placed in an X-ray exposure chamber. The chamber was evacuated to not more than $1 \times 10^{-7}$ Pa. Thereafter, the si wafer as a sample was exposed to a reaction gas $SF_6$, $XeF_2$ or $H_2$ (pressure $1 \times 10^{-4}$ Pa) for 1 minute with cooling the wafer to -100$^\circ$C, whereby the $SF_6$ or $XeF_2$ was adsorbed on the Si wafer surface. The surface on which $SF_6$ was adsorbed caused shift of electrons, and the binding strength between an oxygen atom and Si atom on the surface was reduced. Then, the chamber was re-evacuated and the Si wafer was irradiated with X-ray. Further, the procedure of adsorption-evacuation-irradiation was repeated, in which the total X-ray irradiation dose was 300 mJ/cm$^2$ which was lower than that in Example 1, whereby a native oxide layer having a thickness of about 1.5 nm was removed. Thereafter, $NH_3$ was introduced into the chamber to nitride the Si wafer surface (thickness 2 nm). Further, an $Si_3N_4$ film (thickness 5 nm) was formed by chemical vapor deposition, and an oxide film (thickness 1 nm) was then formed to produce a capacitor. The measurement of an electric field in which the leak current of the capacitor became 1 $\mu$A/cm$^2$ showed that the capacitor from the wafer which had been subjected to the cleaning of this invention exhibited 12 MV/cm, whereas a capacitor from a wafer which had been subjected to only wet wash exhibited 8 MV/cm. It is therefore seen that the quality of the insulator of the capacitor was remarkably improved. In addition, the same effect can be produced by using electron beam in place of the X-ray.

6

Example 3

A boron-doped Si (100) wafer was wet-washed in the same way as in Example 1, and then, placed in an electron beam exposure chamber. The chamber was evacuated to not more than $1 \times 10^{-7}$ Pa, and the Si wafer surface was irradiated with electron beam. The acceleration energy of the electron beam for the irradiation was 2 KeV and the radiation dose thereof was $5 \times 10^{-2}$ C/cm$^2$. After the irradiation, an Al electrode was formed under vacuum, and the contact resistance thereof was measured to show 60 $\Omega$ which corresponded to about 1/3 of that in the case of only wet wash.

Example 4

A boron-doped Si (100) wafer was wet-washed and dried in the same way as in Example 1. Then, the wafer was placed in a soft X-ray exposure chamber, and the chamber was evacuated to not more than $1 \times 10^{-7}$ Pa. The X-ray irradiation method and irradiation conditions were the same as those in Example 1 except that an SF$_6$ gas was introduced into the chamber during the X-ray irradiation so that the gas pressure was in the range of 1 to 10 Torr. Accordingly, a chemical reaction proceeded because of the Si surface excited by an X-ray excitation reaction and activated molecules produced by SF$_6$ decomposition, whereby an oxide layer on the Si surface was selectively removed. Therefore, due to the effect of the SF$_6$ gas, a contact resistance of 50 $\Omega$ could be achieved even at an X-ray irradiation dose of 0.1 J/cm$^2$ which was one digit smaller than that in Example 1. The same effect can be obtained by using electron beam in place of the X-ray.

Example 5

A method of making a two-dimensional quantum effect device (quantum wire) by co-using this invention and a molecular beam epitaxy is explained by reference to Figs. 4A to 4D. An AlAs monomolecular layer 12 was formed on a GaAs crystal wafer 11 according to molecular beam epitaxy (Fig. 4A). Then, the AlAs monomolecular layer 12 was irradiated with X-ray 14 through an X-ray mask 13 having an Au pattern 16 (Fig. 4B). The irradiation method and conditions for the X-ray 14 were the same as those in Example 1. The irradiation dose was 500 mJ/cm$^2$. Accordingly, in those regions of the AlAs monomolecular layer 12 which were irradiated with the X-ray 14, AlAs molecules were selectively desorbed from the GaAs crystal wafer 11, whereby an AlAs monomolecular layer pattern 12 was formed (Fig. 4B). Then, an InAs monomolecular layer 15 was formed on the entire surface according to molecular beam epitaxy (Fig. 4C). Thereafter, the molecular epitaxy methods of the formation of an AlAs layer and the formation of an InAs layer were alternately repeated to form AlAs monomolecular layers 12-2 and 12-3 and InAs monomolecular layers 15-1 and 15-2 alternately, whereby a quantum wire was formed (Fig. 4D). One-dimensional quantum effect device formed by using molecular beam epitaxy has been hitherto possible, whereas the use of the method of solid surface modification of this invention in combination therewith makes it possible to produce a two-dimensional quantum effect device for the first time.

Example 6

This Example describes the steps of cleaning the entire surface of an Si wafer without using any wet process such as acid solution treatment but by using synchrotron radiation as an excitation radiation source. Similarly to Example 1, an unwashed (100) Si wafer is placed in an X-ray exposure chamber, and the chamber is evacuated to not more than $1 \times 10^{-5}$ Pa. Then, a oxygen gas is introduced into the chamber so that the pressure inside the chamber is in the range of 10 to 100 Torr. The Si wafer is irradiated with synchrotron radiation to generate chemically active atomic oxygen due to core electron excitation of oxygen molecules. The atomic oxygen reacts with hydrocarbons adsorbed on the Si surface to form carbon dioxide (CO$_2$) and water (H$_2$O), which are desorbed from the surface. In this case, therefore, to heat the Si wafer to 100 to 200 $^\circ$C is effective to promote the above desorption reaction. In the above procedure, although the thickness of an oxide layer on the Si surface increases to some extent, hydrocarbons adsorbed thereon can be completely removed. Then, the oxide layer on the Si wafer can be removed by irradiating it with synchrotron radiation in the same way as in Example 1. Fig. 5 shows the results of photoelectron spectroscopy of an Si wafer surface treated according to this Example and an Si wafer surface subjected to only wet wash treatment as in Example 1. According to these results, $SiO_2$ remained on the Si wafer surface in the case of wet wash only, whereas the use of the irradiation with synchrotron radiation completely removed $SiO_2$ and produced a clean surface. This Example has a feature that a clean Si wafer surface can be stably obtained since the removal of adsorbed hydrocarbons and oxides can be carried out in vacuum.

**Claims**

1. A method of modification on a surface of a solid sample which comprises carrying out irradiation of the surface of the solid sample with X-ray or electron beam having energy over the ionization energy of core electrons of atoms composing the surface of the solid sample, thereby to selectively desorb specific atoms present on the surface of the solid sample.

2. A method according to claim 1, wherein the irradiation with X-ray or electron beam is carried out in a reaction gas atmosphere.

3. A method according to claim 1, wherein the irradiation with X-ray or electron beam is carried out after an adsorption layer of molecules or atoms is formed on the surface of the solid sample.

4. A method according to claim 1, wherein the irradiation with X-ray or electron beam is carried out selectively on a specific region of the surface of the solid sample.

5. A method of cleaning a semiconductor wafer surface, which comprises carrying out irradiation of a surface of the semiconductor wafer on which a native oxide layer is formed with X-ray or electron beam having energy over the ionization energy of core electrons of atoms composing the surface of the solid sample, thereby to selectively desorb oxygen atoms in the native oxide layer and remove the native oxide layer.

6. A method according to claim 5, wherein the semiconductor wafer is an Si wafer.

7. A method of forming a pattern, which comprises carrying out irradiation of a surface of a semiconductor wafer on which a monomolecular layer is formed with X-ray or electron beam having an energy over the ionization energy of core electrons of atoms composing the surface of the wafer through a mask, thereby to remove an irradiated region of the monomolecular layer and form a pattern of the monomolecular layer.

8. A method of modification on a surface of a solid sample, which comprises a washing step of washing a surface of the solid sample, an irradiation step of carrying out irradiation, in a predetermined atmosphere, of the washed surface of the solid sample with X-ray or electron beam having an energy over the ionization energy of core electrons of atoms composing the surface of the solid sample, and a film-forming step of forming a thin film on the irradiated surface of the solid sample.

9. A method according to claim 8, wherein the predetermined atmosphere is an atmosphere of vacuum.

10. A method according to claim 8, wherein the predetermined atmosphere is an atmosphere of a reaction gas.

11. A method according to claim 10, wherein the reaction gas is $SF_6$, $XeF_2$ or $H_2$.

12. A method according to claim 8, wherein the solid sample is a semiconductor wafer.

FIG. IA

FIG. IB

FIG. IC

FIG. ID

FIG. IE

# F I G. 2

# F I G. 3

F I G. 4A

F I G. 4B

F I G. 4C

F I G. 4D

F I G. 5